# DEMANDE DE BREVET EUROPEEN

(11) **EP 3 863 067 A1**
(43) Date de publication de la demande: **11.08.2021**
(21) Numéro de dépôt: 20156366.5
(22) Date de dépôt: 10.02.2020
(51) Int. Cl.: H01L 31/0224, G04C 10/02, H01L 31/0392, H01L 31/042

(54) **CELLULE PHOTOVOLTAIQUE, NOTAMMENT POUR L'HORLOGERIE**

(71) Demandeur: Patek Philippe SA Genève, 1204 Genève (CH)
(72) Inventeur: HIDE, James, 1228 Plan-les-Ouates (CH)
(74) Mandataire: Micheli & Cie SA

(57) **Abrégé**

La cellule photovoltaïque selon l'invention comprend successivement un substrat transparent (1) destiné à être exposé à la lumière, une couche conductrice transparente (2), du matériau photovoltaïque (3a) et une première électrode (4a, 5a). La cellule photovoltaïque comprend en outre une deuxième électrode (4b, 5b) de polarité opposée à celle de la première électrode (4a, 5a). La deuxième électrode (4b, 5b) est longiligne, en contact électrique avec la couche conductrice transparente (2) et s'étend le long de tout ou partie de la périphérie de la cellule photovoltaïque. La première électrode (4a, 5a) est en contact électrique avec au moins un plot de connexion (8a). La deuxième électrode (4b, 5b) est en contact électrique avec plusieurs plots de connexion (8b).

## Description

La présente invention concerne une cellule photovoltaïque, plus précisément une cellule photovoltaïque comprenant des première et deuxième électrodes dont l'une longe tout ou partie de la périphérie de la cellule.

La présente invention vise à proposer une telle cellule photovoltaïque dont le rendement est amélioré aux fortes illuminations.

La présente invention vise aussi à proposer une telle cellule photovoltaïque qui puisse avoir toute forme souhaitée, pour servir également d'élément décoratif, par exemple dans une pièce d'horlogerie, sans que le choix de la forme de la cellule nuise à son rendement.

A ces fins, il est prévu une cellule photovoltaïque selon la revendication 1 et un dispositif photovoltaïque selon la revendication 8, des modes de réalisation particuliers étant définis dans les revendications dépendantes.

D'autres caractéristiques et avantages de la présente invention apparaîtront à la lecture de la description détaillée suivante faite en référence aux dessins annexés dans lesquels :
- la figure 1 est une vue en coupe schématique d'une cellule photovoltaïque selon un mode de réalisation particulier de l'invention ;
- la figure 2 est une vue arrière plane de la cellule photovoltaïque illustrée à la figure 1, connectée à des fils électriques ;
- les figures 3 et 4 sont des vues en coupe partielles d'un cadran d'horlogerie monté sur une plaque de maintien et comprenant la cellule photovoltaïque illustrée aux figures 1 et 2.

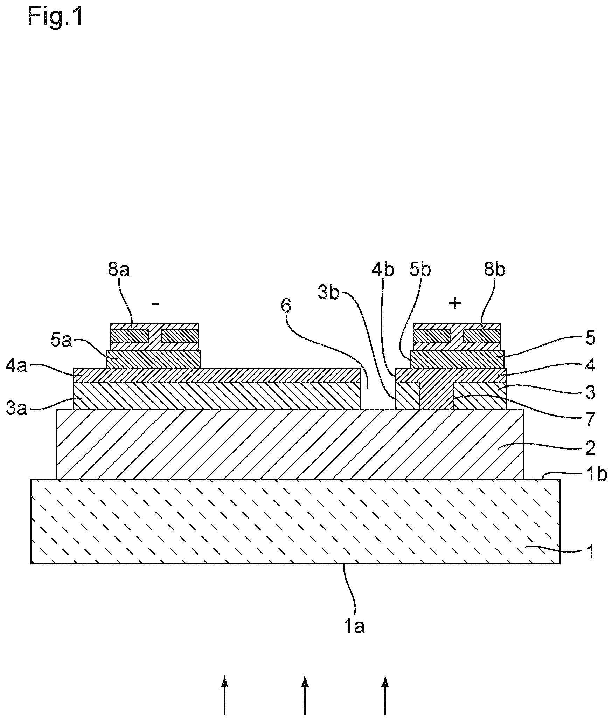

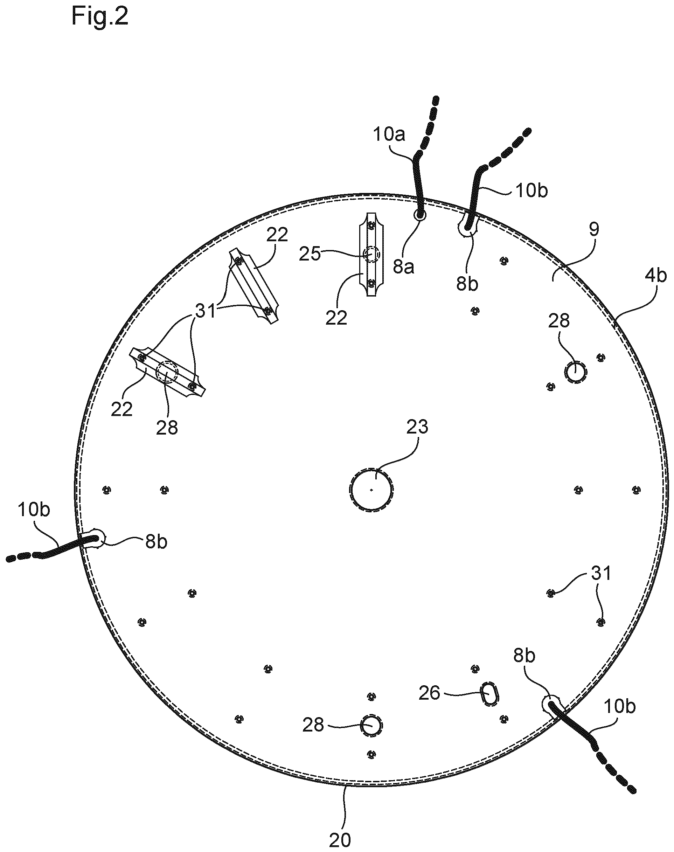

En référence aux figures 1 et 2, une cellule photovoltaïque selon un mode de réalisation particulier de l'invention, de forme ronde dans l'exemple illustré, comprend un substrat transparent 1 présentant une surface avant 1a et une surface arrière 1b, la surface avant 1a étant destinée à être exposée à la lumière, représentée par des flèches à la figure 1. Le substrat transparent 1 est par exemple en verre, de préférence minéral, en quartz, en saphir ou en diamant. Sur la surface arrière 1b du substrat transparent 1 s'étend une couche conductrice transparente de contact avant 2, constituée typiquement d'un oxyde conducteur transparent dit TCO (Transparent Conductive Oxide) tel que l'oxyde de zinc ou l'oxyde d'étain. Sur cette couche conductrice transparente de contact avant 2 se trouve la couche active 3 de la cellule photovoltaïque, qui forme une ou plusieurs diodes et qui peut elle-même être constituée d'un empilement de couches. La couche active 3 possède ainsi des propriétés photovoltaïques et peut être à base de silicium dopé cristallin et/ou amorphe, de préférence amorphe. Sur la couche active 3 est formée une couche conductrice de contact arrière 4, typiquement en aluminium, sur laquelle est formée une couche conductrice 5 faite en un matériau très conducteur tel que l'argent.

L'ensemble constitué par la couche active 3, la couche conductrice de contact arrière 4 et la couche conductrice 5 est divisé en deux sous-ensembles 3a, 4a, 5a et 3b, 4b, 5b séparés par un évidement 6 éventuellement rempli de matière solide électriquement isolante. Le premier sous-ensemble comprenant une partie 3a de la couche active 3, une partie 4a de la couche conductrice de contact arrière 4 et une partie 5a de la couche conductrice 5 couvre la plus grande partie de la surface de la couche conductrice transparente de contact avant 2 et donc de la surface de la cellule photovoltaïque. Dans ce premier sous-ensemble, la couche conductrice de contact arrière 4, 4a et la couche conductrice 5, 5a forment ensemble une première électrode 4a, 5a. Le deuxième sous-ensemble 3b, 4b, 5b comprenant une autre partie 3b de la couche active 3, une autre partie 4b de la couche conductrice de contact arrière 4 et une autre partie 5b de la couche conductrice 5 couvre une petite partie de la surface de la couche conductrice transparente de contact avant 2 et donc de la cellule photovoltaïque et s'étend le long de tout ou partie de la périphérie de la cellule photovoltaïque. Dans le deuxième sous-ensemble 3b, 4b, 5b, la couche conductrice de contact arrière 4, 4b et la couche conductrice 5, 5b forment ensemble une deuxième électrode de polarité, par exemple positive, opposée à celle de la première électrode 4a, 5a et qui entoure la première électrode 4a, 5a. Un évidement 7 pratiqué dans la couche active 3, 3b dans le deuxième sous-ensemble 3b, 4b, 5b est rempli de matière conductrice, plus précisément de la matière formant la couche conductrice de contact arrière 4, de manière à relier électriquement la couche conductrice transparente de contact avant 2 à la partie 4b de la couche conductrice de contact arrière 4, donc à la deuxième électrode 4b, 5b.

Les couches 2 et 3 peuvent être obtenues par dépôt chimique en phase vapeur. Les couches 4 et 5 peuvent être obtenues respectivement par dépôt physique en phase vapeur et par sérigraphie.

Des plots de connexion 8a, 8b sont formés sur la couche conductrice 5. Ces plots de connexion 8a, 8b sont par exemple en alliage cuivre-nickel-or avec inserts de renfort mécanique en polyimide. Un ou plusieurs de ces plots, 8a, sont en contact électrique avec la couche conductrice 5 dans le premier sous-ensemble 3a, 4a, 5a. Plusieurs de ces plots (trois dans l'exemple illustré à la figure 2), désignés par 8b, sont en contact électrique avec la couche conductrice 5 dans le deuxième sous-ensemble 3b, 4b, 5b et sont de préférence régulièrement répartis le long de la deuxième électrode 4b, 5b. La couche conductrice 5 peut être présente sur toute la surface de la couche conductrice de contact arrière 4 ou seulement sous les plots de connexion 8a, 8b. Une couche isolante de protection 9, non représentée sur la figure 1 mais visible à la figure 2, peut recouvrir la face arrière de la cellule photovoltaïque à l'exception des plots de connexion 8a, 8b.

A ces plots de connexion 8a, 8b peuvent être connectés, par exemple par brasage, des fils électriques respectifs 10a, 10b permettant de relier électriquement les électrodes 4a, 5a et 4b, 5b à un dispositif consommateur de l'électricité produite par la cellule photovoltaïque. Typiquement, ces fils électriques 10a, 10b ont une plus grande section que la deuxième électrode 4b, 5b. A une certaine distance des plots de connexion 8a les fils électriques 10a connectés à ces plots de connexion 8a peuvent se rejoindre pour former un seul câble. De même, à une certaine distance des plots de connexion 8b les fils électriques 10b connectés à ces plots de connexion 8b peuvent se rejoindre pour former un seul câble.

Le fait d'associer plusieurs plots de connexion 8b et plusieurs fils électriques 10b à la deuxième électrode 4b, 5b permet d'éviter ou d'atténuer les chutes de tension dues à une saturation de cette électrode 4b, 5b lorsque la cellule reçoit de fortes illuminations, en raccourcissant le chemin à parcourir dans l'électrode 4b, 5b par le courant produit. Le rendement est ainsi amélioré. Il est en effet avantageux que la deuxième électrode 4b, 5b et plus généralement le deuxième sous-ensemble 3b, 4b, 5b ait une petite section afin de laisser le maximum de place à la surface active que définit le premier sous-ensemble 3a, 4a, 5a.

L'augmentation du rendement est assez considérable dans le cas d'une cellule photovoltaïque de forme complexe, par exemple en forme de croix de Calatrava, de croix de Malte ou de chiffre romain. Dans un tel cas, le périmètre de la cellule, correspondant sensiblement à la longueur de la deuxième électrode, est grand par rapport à la surface de la cellule. Le rapport du périmètre sur la surface (le périmètre étant ici le périmètre intérieur de la deuxième électrode, la surface étant la surface délimitée par ce périmètre intérieur) peut en effet être supérieur à 5 cm⁻¹, voire à 7 cm⁻¹, voire à 10 cm⁻¹, voire plus encore. Les pertes ohmiques dans la deuxième électrode affectent alors de manière importante le rendement, qui peut chuter de plusieurs dizaines de pourcents. Ces pertes peuvent être compensées en multipliant les plots de connexion sur la deuxième électrode.

La présence de la partie 3b de la couche active 3 facilite la fabrication de la cellule photovoltaïque en permettant aux électrodes 4a, 5a et 4b, 5b d'être coplanaires. Dans une variante de l'invention, toutefois, cette partie 3b est supprimée et la deuxième électrode 4b, 5b se trouve directement sur la face arrière de la couche conductrice transparente de contact avant 2.

La couche conductrice 5 est avantageuse en ce qu'elle augmente la conductivité des électrodes. Elle peut cependant être supprimée.

Inversement, une ou plusieurs couches supplémentaires pourraient être intercalées entre les couches 1 à 5.

Le mode de réalisation illustré sur les figures est une cellule photovoltaïque à contacts arrière. Les électrodes 4a, 5a et 4b, 5b de polarités négative et positive sont en effet en face arrière de la cellule. Ce type de cellule photovoltaïque présente généralement un meilleur rendement que les cellules à contacts avant et arrière et est en outre plus esthétique du fait de l'absence d'électrode sur la face avant. Il va néanmoins de soi que le principe de l'invention peut s'appliquer de la même manière à une cellule photovoltaïque à contacts avant et arrière.

L'utilisation des plots de connexion 8a, 8b facilite la connexion des fils électriques 10a, 10b aux électrodes 4a, 5a et 4b, 5b. On pourrait néanmoins les supprimer et connecter directement, par exemple par brasage, les fils électriques 10a, 10b aux électrodes 4a, 5a et 4b, 5b.

La cellule photovoltaïque selon l'invention trouve une application particulièrement avantageuse dans l'horlogerie, où elle peut par exemple être montée sur un cadran de montre, de pendulette ou d'horloge ou faire partie d'un tel cadran, pour alimenter en énergie électrique un moteur électrique qui remonte un barillet ou un accumulateur électrique, tel que pile rechargeable ou condensateur, qui ensuite alimente un moteur électrique qui remonte un barillet. Il est aussi possible d'alimenter par la cellule photovoltaïque, directement ou via un accumulateur électrique, un système d'éclairage de la montre, de la pendulette ou de l'horloge.

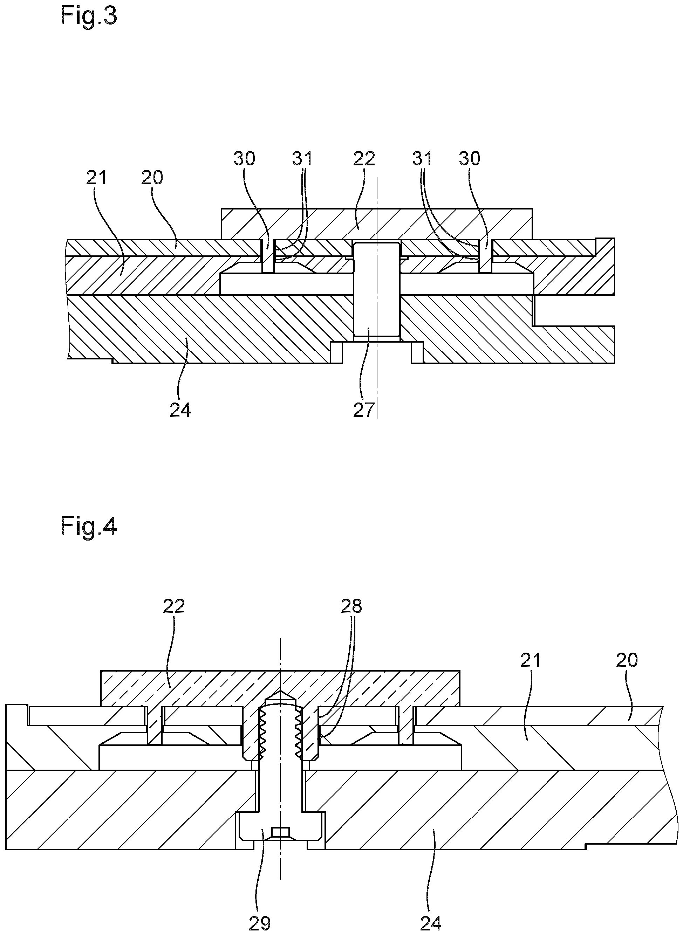

Les figures 2 à 4 montrent un exemple de réalisation dans lequel la cellule photovoltaïque, désignée par le repère 20, est une plaque supérieure d'un cadran d'horlogerie qui comprend en outre une plaque inférieure de support 21 et douze index 22 marquant les heures (dont seulement trois sont représentés à la figure 2) placés sur la plaque supérieure 20. Un trou central 23 traverse les plaques supérieure et inférieure 20, 21 pour permettre le passage des axes des aiguilles indicatrices. Ces plaques supérieure et inférieure 20, 21 sont montées sur une plaque de maintien 24 qui peut être la platine du mouvement horloger ou une plaque fixée sur la platine du mouvement horloger. Un trou rond 25 et un trou oblong 26 pratiqués dans les plaques supérieure et inférieure 20, 21 reçoivent des goupilles 27 chassées dans la plaque de maintien 24 pour le guidage de ces plaques 20, 21, par la suppression de trois degrés de liberté, avant leur fixation. D'autres trous 28 servent à la fixation des plaques supérieure et inférieure 20, 21 sur la plaque de maintien 24 par des vis 29.

Selon une caractéristique avantageuse, les vis 29 sont des vis de compression dont la tête s'appuie contre la plaque de maintien 24 et qui sont vissées dans certains des index 22 pour prendre en sandwich les plaques supérieure et inférieure 20, 21 entre ces index 22 et la plaque de maintien 24. Ce mode de fixation assure un positionnement plus précis du cadran 20, 21, 22 que les modes de fixation traditionnels où le cadran est collé sur la plaque de maintien ou monté au moyen de pieds de cadran, et présente en outre l'avantage d'être démontable. De plus, les trous 28 dans lesquels passent les vis de compression 29 sont cachés par les index 22, comme le sont également les trous de guidage 25, 26 qui n'ont donc pas besoin d'être cachés par le réhaut de la boîte de la pièce d'horlogerie, permettant ainsi au cadran d'avoir un moins grand diamètre. Pour leur fixation sur la plaque supérieure 20, les index 22 comprennent des pieds d'index 30 qui passent dans des trous 31 des plaques supérieure et inférieure 20, 21 et qui sont maintenus par collage.

Dans une variante, la plaque inférieure 21 est supprimée et la plaque supérieure 20 est serrée directement entre les index 22 et la plaque de maintien 24 par les vis de compression 29.

L'homme du métier comprendra que le mode de fixation proposé ci-dessus peut être utilisé pour tout cadran, y compris des cadrans ne comprenant pas de cellule photovoltaïque.

## Revendications

1. Cellule photovoltaïque comprenant successivement un substrat transparent (1) destiné à être exposé à la lumière, une couche conductrice transparente (2), du matériau photovoltaïque (3a) et une première électrode (4a, 5a), la cellule photovoltaïque comprenant en outre une deuxième électrode (4b, 5b) de polarité opposée à celle de la première électrode (4a, 5a), la deuxième électrode (4b, 5b) étant longiligne, en contact électrique avec la couche conductrice transparente (2) et s'étendant le long de tout ou partie de la périphérie de la cellule photovoltaïque, la première électrode (4a, 5a) étant en contact électrique avec au moins un plot de connexion (8a), la deuxième électrode (4b, 5b) étant en contact électrique avec plusieurs plots de connexion (8b).

2. Cellule photovoltaïque selon la revendication 1, **caractérisée en ce que** la deuxième électrode (4b, 5b) s'étend tout le long de la périphérie de la cellule photovoltaïque.

3. Cellule photovoltaïque selon la revendication 2, **caractérisée en ce que** le rapport du périmètre intérieur de la deuxième électrode (4b, 5b) sur la surface délimitée par ce périmètre intérieur est supérieur à 5 cm⁻¹, de préférence à 7 cm⁻¹, de préférence à 10 cm⁻¹.

4. Cellule photovoltaïque selon l'une quelconque des revendications 1 à 3, **caractérisée en ce que** lesdits plusieurs plots de connexion (8b) sont régulièrement répartis le long de la deuxième électrode (4b, 5b).

5. Cellule photovoltaïque selon l'une quelconque des revendications 1 à 4, **caractérisée en ce que** lesdits plusieurs plots de connexion (8b) sont au moins au nombre de trois.

6. Cellule photovoltaïque selon l'une quelconque des revendications 1 à 5, **caractérisée en ce que** le matériau photovoltaïque (3a), qui porte la première électrode (4a, 5a), est une première partie d'une couche active (3) dont une deuxième partie (3b), séparée de la première partie (3a), porte la deuxième électrode (4b, 5b), la deuxième électrode (4b, 5b) étant reliée électriquement à la couche conductrice transparente (2) par de la matière conductrice traversant la deuxième partie (3b) de la couche active (3).

7. Dispositif photovoltaïque comprenant une cellule photovoltaïque selon l'une quelconque des revendications 1 à 6 et des fils électriques (10a, 10b) connectés auxdits plots de connexion (8a, 8b) pour relier la cellule photovoltaïque à un dispositif à alimenter électriquement.

8. Dispositif photovoltaïque comprenant une cellule photovoltaïque, la cellule photovoltaïque comprenant successivement un substrat transparent (1) destiné à être exposé à la lumière, une couche conductrice transparente (2), du matériau photovoltaïque (3a) et une première électrode (4a, 5a), la cellule photovoltaïque comprenant en outre une deuxième électrode (4b, 5b) de polarité opposée à celle de la première électrode (4a, 5a), la deuxième électrode (4b, 5b) étant longiligne, en contact électrique avec la couche conductrice transparente (2) et s'étendant le long de tout ou partie de la périphérie de la cellule photovoltaïque, le dispositif photovoltaïque comprenant en outre au moins un fil électrique (10a) connecté à la première électrode (4a, 5a) et plusieurs fils électriques (10b) connectés à la deuxième électrode (4b, 5b) en des points respectifs.

9. Dispositif photovoltaïque selon la revendication 8, **caractérisé en ce que** la deuxième électrode (4b, 5b) s'étend tout le long de la périphérie de la cellule photovoltaïque.

10. Dispositif photovoltaïque selon la revendication 9, **caractérisée en ce que** le rapport du périmètre intérieur de la deuxième électrode (4b, 5b) sur la surface délimitée par ce périmètre intérieur est supérieur à 5 cm⁻¹, de préférence à 7 cm⁻¹, de préférence à 10 cm⁻¹.

11. Dispositif photovoltaïque selon l'une quelconque des revendications 8 à 10, **caractérisé en ce que** lesdits points respectifs sont régulièrement répartis le long de la deuxième électrode (4b, 5b).

12. Dispositif photovoltaïque selon l'une quelconque des revendications 8 à 11, **caractérisé en ce que** lesdits points respectifs sont au moins au nombre de trois.

13. Dispositif photovoltaïque selon l'une quelconque des revendications 8 à 12, **caractérisé en ce que** le matériau photovoltaïque (3a), qui porte la première électrode (4a, 5a), est une première partie d'une couche active (3) dont une deuxième partie (3b), séparée de la première partie (3a), porte la deuxième électrode (4b, 5b), la deuxième électrode (4b, 5b) étant reliée électriquement à la couche conductrice transparente (2) par de la matière conductrice traversant la deuxième partie (3b) de la couche active (3).

14. Pièce d'horlogerie comprenant une cellule photovoltaïque selon l'une quelconque des revendications 1 à 6 ou un dispositif photovoltaïque selon l'une quelconque des revendications 7 à 13.

15. Pièce d'horlogerie selon la revendication 14, **caractérisée en ce que** la cellule photovoltaïque est une plaque de cadran (20) fixée à une plaque de maintien (24) par des vis de compression (29) qui sont vissées dans des index (22) portés par la plaque de cadran (20) et dont la tête s'appuie contre la plaque de maintien (24).

16. Pièce d'horlogerie selon la revendication 14 ou 15, **caractérisée en ce que** la cellule photovoltaïque est une plaque de cadran (20) portant des index (22), une partie au moins de ces index (22) cachant des trous de guidage (25, 26) formés dans la plaque de cadran (20).
